# EUROPÄISCHE PATENTSCHRIFT

(11) **EP 1 425 804 B1**
(45) Veröffentlichungstag und Bekanntmachung des Hinweises auf die Patenterteilung: **09.02.2005**
(21) Anmeldenummer: 02798692.6
(22) Anmeldetag: 03.09.2002
(51) Int. Cl.: H01L 41/053, H01L 41/083

(54) **VORRICHTUNG UMFASSEND EINEN PIEZOELEKTRISCHEN AKTOR**
DEVICE WITH A PIEZOELECTRIC ACTUATOR
DISPOSITIF DOTE D'UN ACTIONNEUR PIEZOELECTRIQUE

(30) Priorität: 12.09.2001 DE 10144919
(43) Veröffentlichungstag der Anmeldung: 09.06.2004
(73) Patentinhaber: SIEMENS AKTIENGESELLSCHAFT, 80333 München (DE)
(72) Erfinder: FREUDENBERG, Hellmut, 93080 Grossberg (DE); KLÜGL, Wendelin, 92358 Seubersdorf (DE); UNRUH, Marcus, 93197 Zeitlarn (DE); VOIGT, Andreas, 93055 Regensburg (DE); ZUMSTRULL, Claus, 93128 Regenstauf (DE)
(86) Internationale Anmeldenummer: PCT/DE2002/003248
(87) Internationale Veröffentlichungsnummer: WO 2003/026033

(56) Entgegenhaltungen:
- DE-A- 19 653 555
- DE-A- 19 715 487
- DE-A- 19 818 068
- DE-C- 19 928 187
- US-A- 4 803 393

## Beschreibung

Die Erfindung betrifft eine Vorrichtung umfassend einen piezoelektrischen Aktor, welcher zwei Stirnflächen sowie zwei elektrisch leitfähige Kontaktbahnen aufweist, deren jede den Aktor ausgehend zumindest einer Stirnfläche durchquert und welcher zwischen zwei metallischen Platten, deren jede an einer Stirnfläche angeordnet ist, eingespannt ist.

Hinweise auf eine solche Vorrichtung und auf den maßgeblichen technologischen Hintergrund sind erhältlich aus folgenden Dokumenten: WO 98/47187 A, EP 0 948 062 A, DE 198 18 036 A, DE 199 30 585 A, DE 198 60 001 A, DE 199 10 111 A und DE 198 18 068.

Die Erfindung bezieht sich insbesondere auf eine Vorrichtung, in welcher der Aktor ein keramischer Vielschicht-Aktor ist und dementsprechend aus vielen abwechselnd angeordneten piezoelektrischen keramischen Schichten und metallisch leitfähigen Schichten besteht. Eine solche Vorrichtung findet insbesondere Anwendung als Aktor in einer Kraftstoffeinspritzeinrichtung für einen Verbrennungsmotor und wird bevorzugt eingesetzt in einer Kraftstoffeinspritzeinrichtung des "Common-Rail"-Typs in einem Dieselmotor mit mehreren Zylindern.

In dieser Vorrichtung sind elektrisch leitfähige Teile des Aktors den metallischen Platten an seinen Stirnseiten vergleichsweise eng benachbart. Deswegen kann es, unter Umständen unterstützt durch einen Bruch einer elektrisch leitfähigen Komponente, zu einem elektrischen Kurzschluss zwischen elektrisch leitfähigen Teilen des Aktors und einer Platte kommen. Ein solcher Kurzschluss kann zum vollständigen Funktionsausfall der Vorrichtung führen. Auch die üblicherweise vorgesehene Umhüllung des Aktors abseits seiner Stirnfläche mit einer lateralen Isolierung hilft nicht weiter, da diese laterale Isolierung zweckmäßig einen gewissen Abstand von den Platten einhält und somit die durch einen Kurzschluss am meisten gefährdeten Bereiche des Aktors, die der Platte unmittelbar benachbart sind, nicht schützen kann.

Dementsprechend geht die Erfindung aus von der Aufgabe, eine Vorrichtung der eingangs genannten Art derart weiterzubilden, dass ein Kurzschluss zwischen einer elektrisch leitfähigen Komponente des Aktor und einer der Platten sicher vermieden ist.

Zur Lösung dieser Aufgabe angegeben wird eine Vorrichtung umfassend einen piezoelektrischen Aktor, welcher
a) zwei Stirnflächen, sowie zwei elektrisch leitfähige Kontaktbahnen aufweist, deren jede den Aktor ausgehend von zumindest einer Stirnfläche durchquert;
b) zwischen zwei metallischen Platten, deren jede an einer Stirnfläche angeordnet ist, eingespannt ist, bei welcher Vorrichtung zusätzlich zwischen jeder Stirnfläche und der daran angeordneten Platte eine elektrisch isolierende Isolierschicht angeordnet ist.

Diese Isolierschicht, bzw. diese Isolierschichten (eine an jeder Stirnfläche des Aktors), vermögen den besagten Kurzschluss sicher zu verhindern. Damit ist die Funktionssicherheit der Vorrichtung erhöht, Funktionsausfälle durch Kurzschlüsse sind vermieden und somit ist insbesondere die Ausschussrate im Rahmen der Serienproduktion solcher Vorrichtungen verringert.

Die Isolierschicht besteht vorzugsweise aus Keramik. Dabei kann die Isolierschicht mit einer Platte stoffschlüssig verbunden und dazu vorzugsweise ausgeführt als gespritzte, insbesondere plasmagespritzte oder emaillierte Schicht, öder ein separates Bauteil sein.

Der Aktor ist vorzugsweise ein keramischer Vielschicht-Aktor der oben beschriebenen Art.

Ebenfalls vorzugsweise ist der Aktor zwischen den Stirnflächen von einer lateralen Isolierung umgeben, wobei diese laterale Isolierung weiter vorzugsweise von jeder Isolierschicht beabstandet ist. Dies dient dazu, die laterale Isolierung von mechanischer Spannung, wie sie durch die Einspannung des Aktors zwischen den Platten gegeben ist und im Rahmen des Betriebs des Aktors unter Umständen noch verstärkt wird, zu entlasten. Auf die Beschreibung eines bevorzugten Ausführungsbeispiels dieser lateralen Isolierung weiter unten wird verwiesen.

Besonders bevorzugt ist es, dass jede Kontaktbahn durch eine zugehörige Aussparung einer Platte hindurch fortgesetzt ist. Dies erleichtert die elektrische Kontaktierung des Aktors.

Die Platten sind vorzugsweise über ein Federelement schlüssig miteinander verbunden; weiter vorzugsweise ist das Federelement dabei eine den Aktor umgebende Rohrfeder.

Die Vorrichtung ist insbesondere ein Bestandteil einer Kraftstoffeinspritzeinrichtung für einen Verbrennungsmotor und dient dabei insbesondere als Steuerelement in einer Kraftstoffeinspritzeinrichtung des "Common-Rail"-Typs für einen Dieselmotor-mit mehreren Zylindern.

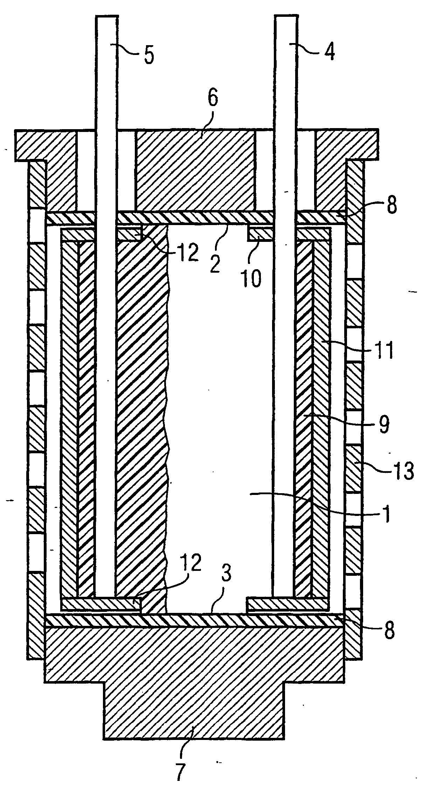

Ein Ausführungsbeispiel der Erfindung ist in der Zeichnung dargestellt. Die Zeichnung ist lediglich als Skizze aufzufassen; es wird nicht geltend gemacht, dass sie eine maßstabsgerechte Widergabe einer realen Vorrichtung sei.

Die aus der Figur erkennbare Vorrichtung umfasst einen piezoelektrischen Aktor 1, welcher zwei Stirnflächen 2 und 3 sowie zwei elektrisch leitfähige Kontaktbahnen 4 und 5 aufweist, wobei jede Kontaktbahn 4 oder 5 den Aktor 1 ausgehend von zumindest einer Stirnfläche 2 oder 3 durchquert - tatsächlich werden beide Stirnflächen 2 und 3 von den Kontaktbahnen 4 und 5 durchquert.

Der Aktor 1 ist ein Vielschicht-Aktor, umfassend viele piezoelektrische Schichten, die durch metallische Schichten voneinander getrennt sind. Jede metallische Schicht ist dabei, beispielsweise über einen Draht (von einer Darstellung wurde der Übersicht halber abgesehen), mit einer der Kontaktbahnen 4 und 5 verbunden. Durch das Anlegen einer elektrischen Spannung zwischen die Kontaktbahnen 4 und 5 wird somit eine Verformung des Aktors 1 erreicht.

Der Aktor 1 ist eingespannt zwischen zwei metallische Platten 6 und 7, deren jede an einer Stirnfläche 2 oder 3 angeordnet ist. Dabei stellt sich das Problem, dass die elektrische Isolierung zwischen jeder Platte 6 oder 7 und dem Aktor 1 derart gut ausgeführt werden muss, dass sie selbst dann gewährleistet bleibt, wenn ein Kontaktmittel zwischen einer metallischen Schicht des Aktors 1 und einer Kontaktbahn 4 oder 5 bricht und sich der betroffenen Platte 6 oder 7 möglicherweise stark annähert. In einem solchen Fall kann es zu einem elektrischen Kontakt oder einem elektrischen Überschlag kommen, wodurch in jedem Fall ein Kurzschluss ausgelöst und der Aktor 1 möglicherweise außer Funktion gesetzt wird, abgesehen von weiteren möglichen Schäden. Um dies zu verhindern, ist zwischen jeder Stirnfläche 2 oder 3 der daran angeordneten Platte 6 bzw. 7 eine elektrisch isolierende Isolierschicht 8 angeordnet. Diese besteht aus einer Keramik.

Eine erste Alternative sieht vor, dass die Isolierschicht 8 mit der entsprechenden Platte 6 oder 7 stoffschlüssig verbunden ist. Dann ist die Isolierschicht 8 insbesondere als gespritzte oder emaillierte Schicht ausgeführt. Gemäß einer zweiten Alternative ist die Isolierschicht 8 als separates Bauteil ausgeführt und wird bei der Montage der Vorrichtung zwischen den Aktor 1 und die entsprechende Platte 6 oder 7 gelegt.

Zwischen den Stirnflächen 2 und 3 ist der Aktor 1 von einer lateralen Isolierung umgeben umfassend eine viskose oder viskoelastische Masse 9, welche von einem mit isolierenden Endplatten 10 versehene isolierenden Zylinder 11 umgeben ist. Die Endplatten 10 greifen in Aussparungen 12 der Stirnflächen 2 und 3 ein.

Die Platten 6 und 7 sind über ein Federelement 13, vorliegend eine geschlitzte Rohrfeder 13, kraftschlüssig miteinander verbunden. Dabei umgibt die Rohrfeder 13 den Aktor 1 vollständig und schützt ihn gleichzeitig vor Beschädigung.

Die Vorrichtung ist ein Bestandteil einer Kraftstoffeinspritzeinrichtung für einen Verbrennungsmotor, wobei sie als Betätigungselement für ein Einspritzventil dient.

Die Vorrichtung zeichnet sich aus durch einen zuverlässigen Betrieb, der selbst dann gewährleistet ist, wenn die Vorrichtung einer Beeinträchtigung aufgrund einer gebrochenen elektrischen Verbindung innerhalb des Aktors ausgesetzt ist. Dies zeichnet sie für eine Verwendung im Rahmen der Automobiltechnik besonders aus.

## Patentansprüche

1. Vorrichtung umfassend einen piezoelektrischen Aktor (1), welcher
a) zwei Stirnflächen (2, 3) sowie zwei elektrisch leitfähige Kontaktbahnen (4, 5) aufweist, deren jede den Aktor (1) ausgehend von zumindest einer Stirnfläche (3) durchquert; und
b) zwischen zwei metallischen Platten (6, 7), deren jede an einer Stirnfläche (2, 3) angeordnet ist, eingespannt ist;
**dadurch gekennzeichnet, dass** zwischen jeder Stirnfläche (2, 3) und der darin angeordneten Platte (6, 7) eine elektrisch isolierende Isolierschicht (8) angeordnet ist.

2. Vorrichtung nach Anspruch 1, bei der die Isolierschicht (8) aus Keramik besteht.

3. Vorrichtung nach Anspruch 2, bei der die Isolierschicht (8) mit der entsprechenden Platte (6, 7) stoffschlüssig verbunden ist.

4. Vorrichtung nach Anspruch 3, bei der die Isolierschicht (8) ausgewählt ist aus der Gruppe-umfassend gespritzte Schicht und emaillierte Schicht.

5. Vorrichtung nach Anspruch 2, bei der die Isolierschicht (8) ein separates Bauteil ist.

6. Vorrichtung nach einem der vorigen Ansprüche, bei der der Aktor (1) ein keramischer Vielschicht-Aktor (1) ist.

7. Vorrichtung nach einem der vorigen Ansprüche, bei der der Aktor (1) zwischen den Stirnflächen (2, 3) von einer lateralen Isolierung (9, 10, 11) umgeben ist.

8. Vorrichtung nach Anspruch 7, bei der die laterale Isolierung (.9, 10, 11) von jeder Isolierschicht (8) beabstandet ist.

9. Vorrichtung nach einem der vorigen Ansprüche, bei der jede Kontaktbahn (4, 5) durch eine zugehörige Aussparung (12) einer Platte (6, 7) hindurch fortgesetzt ist.

10. Vorrichtung nach einem der vorigen Ansprüche, bei der die Platten (6, 7) über ein Federelement (13) kraftschlüssig miteinander verbunden sind.

11. Vorrichtung nach Anspruch 10, bei der das Federelement (13) eine Rohrfeder (13) ist, welche den Aktor (1) umgibt.

12. Vorrichtung nach einem der vorigen Ansprüche, welche ein Bestandteil einer Kraftstoffeinspritzeinrichtung für einen Verbrennungsmotor ist.

## Claims

1. Device comprising a piezoelectric actuator (1), which
a) has two faces (2, 3) and two electroconductive contact paths (4, 5), each traversing said actuator (1) starting from at least one face (3); and
b) is clamped between two metallic plates (6, 7), each arranged against a face (2, 3);
**characterised in that** an electro-insulating layer (8) is arranged between each face (2, 3) and the plate (6, 7) arranged against it.

2. Device according to Claim 1, wherein the insulating layer (8) is made of a ceramic material.

3. Device according to Claim 2, wherein the insulating layer (8) is connected in a material-actuated manner to the corresponding plate (6, 7).

4. Device according to Claim 3, wherein the insulating layer (8) is selected from the group comprising sprayed layers and enamelled layers.

5. Device according to Claim 2, wherein the insulating layer (8) is a separate component.

6. Device according to one of the preceding Claims, wherein the actuator (1) is a ceramic multilayer actuator (1).

7. Device according to one of the preceding Claims, wherein the actuator (1) is enclosed by lateral insulation (9, 10, 11) between the faces (2, 3).

8. Device according to Claim 7, wherein the lateral insulation (9, 10, 11) is at a distance from each insulating layer (8).

9. Device according to one of the preceding Claims, wherein each contact path (4, 5) is continued through an associated recess (12) in a plate (6, 7).

10. Device according to one of the preceding Claims, wherein the plates (6, 7) are connected in a force-actuated manner via a spring element (13).

11. Device according to Claim 10, wherein the spring element (13) is a tube spring (13), which encloses the actuator (1).

12. Device according to one of the preceding Claims, which is a component of a fuel injection device for an internal combustion engine.

## Revendications

1. Dispositif comprenant un actionneur (1 ) piezoélectrique qui comprend
a) deux faces frontales (2, 3) ainsi que deux bandes de contact (4, 5) électro-conductrices, chacune traversant l'actionneur (1) en partant d'au moins une face frontale (3); et b) qui est serré entre deux plaques (6, 7) métalliques, chacune étant disposée contre une face frontale (2, 3);
**caractérisé en ce qu'**entre chaque face frontale (2, 3) et la plaque (6, 7) disposée contre elle, est disposée une couche (8), électriquement isolante.

2. Dispositif selon la revendication 1, dans lequel la couche isolante (8) est en céramique.

3. Dispositif selon la revendication 2, dans lequel la couche isolante (8) est reliée par liaison de matière avec la plaque correspondante (6, 7).

4. Dispositif selon la revendication 3, dans lequel la couche isolante est choisie dans un groupe comprenant une couche projetée et une couche émaillée.

5. Dispositif selon la revendication 2, dans lequel la couche isolante (8) est un élément séparé.

6. Dispositif selon l'une quelconque des revendications précédentes, dans lequel l'actionneur (1) est un actionneur (1) céramique à plusieurs couches.

7. Dispositif selon l'une quelconque des revendications précédentes, dans lequel l'actionneur (1) est entouré par une isolation latérale (9, 10, 11) entre les faces frontales (2, 3).

8. Dispositif selon la revendication 7, dans lequel l'isolation latérale (9, 10, 11) est à une certaine distance de chaque couche isolante (8).

9. Dispositif selon l'une quelconque des revendications précédentes, dans lequel chaque bande de contact (4, 5) se prolonge à travers un évidement (12) adéquat dans une plaque (6, 7).

10. Dispositif selon l'une quelconque des revendications précédentes, dans lequel les plaques (6, 7) sont reliées ensemble par coopération de forces au moyen d'un ressort (13).

11. Dispositif selon la revendication 10, dans lequel le ressort (13) est un tube-ressort (13) qui entoure l'actionneur (1).

12. Dispositif selon l'une quelconque des revendications précédentes, celui-ci étant un composant d'un dispositif d'injection de carburant pour un moteur à combustion interne.
